(19) Europäisches Patentamt
European Patent Office
Office européen des brevets

(11) Publication number: **0 381 899 A2**

(12) # EUROPEAN PATENT APPLICATION

(21) Application number: 89313681.2

(22) Date of filing: 28.12.89

(51) Int. Cl.5: C08F 283/10, C08F 283/00, C08G 59/40

(30) Priority: 06.02.89 JP 27294/89

(43) Date of publication of application: 16.08.90 Bulletin 90/33

(84) Designated Contracting States: BE DE FR GB

(71) Applicant: **SOMAR CORPORATION**
**11-2, Ginza 4-chome Chuo-ku**
**Tokyo(JP)**

(72) Inventor: **Fujii, Ryuichi**
**33-8-10-206, Harayama 2-chome**
**Urawa-shi Saitama-ken(JP)**
Inventor: **Ogitani, Osamu 807,**
**Mitsui-Sengendai Height**
**1051-2, Oaza-Kamimakuri**
**Koshigaya-shi Saitama-ken(JP)**
Inventor: **Shirose, Toru**
**West-Town 207 1-3-45 Gamounishimachi**
**Koshigaya-shi Saitama-ken(JP)**

(74) Representative: **Allam, Peter Clerk et al**
**LLOYD WISE, TREGEAR & CO. Norman**
**House 105-109 Strand**
**London WC2R 0AE(GB)**

(54) **Thermosetting composition.**

(57) A liquid, thermosetting composition is disclosed which contains (a) 10-70 % by weight of an epoxy resin, (b) 10-70 % by weight of a maleimide-triazine resin, (c) 5-60 % by weight of a polymerizable compound having at least two acrylate or methacrylate groups, and (d) 0.1-10 % by weight of a radical polymerization initiator, the amount of each of ingredients (a) through (d) being based on the total weight of ingredients (a) through (c). The composition gives a solid, thermosetting resin when heated at a low temperature or when irradiated by actinic light by reaction of ingredients (c) and (e), and the solidified resin in turn affords a cured resin having good moisture-proofing and insulting properties when heated at a high temperature by reaction of ingredients (a) and (b).

EP 0 381 899 A2

This invention relates generally to a liquid thermosetting composition and, more specifically, to a liquid thermosetting composition which affords a solid thermosetting resin, generally called "B-stage" resin, when heated at a low temperature or irradiated by an actinic light and which gives, upon being heated at a high temperature, a cured product having excellent thermal stability, excellent moisture-proofing property and excellent electrically insulating property.

There is a known thermosetting resin composition containing an epoxy resin, an acrylic or methacrylic (hereinafter referred to as "(meth)acrylic") anhydride and a radical polymerization initiator (Japanese Tokkyo Kokai No. 63-145,322). This composition, when heated or irradiated by UV rays, gives a solid thermosetting product as a result of ring-open polymerization of the (meth)acrylic anhydride with the epoxy resin still remaining uncured. When the solid product is heated at a high temperature, the epoxy resin reacts with the polymerized (meth)acrylic anhydride which serves to function as a curing agent to give a cured product with good thermal resistance. The known composition has a problem that it emanates a strong odor of the anhydride and is hygroscopic in nature. Further, the cured product is poor in moisture-proofing property so that the insulating property thereof becomes poor during use.

Japanese Tokkyo Kokai No. 63-154,780 discloses an adhesive composition which affords a B-stage resin when heated at a low temperature and which contains (I) a mixture of (a) a thermosetting epoxymethacrylate resin obtained by addition polymerization of methacrylic acid with an epoxy resin (b) a copolymerizable cross-linking agent and (c) a thermal polymerization initiator, (II) a mixture of an epoxy resin and a curing agent, and (III) a filler and a thixotropic agent. This composition has a problem because the cured product obtained from the B-stage resin is poor in moisture proofing property and in electrically insulating property.

The present invention has been made with the foregoing problems of the conventional thermosetting compositions in view.

In accordance with the present invention there is provided a liquid, thermosetting composition comprising the following ingredients (a) through (d):

(a) 10-70 % by weight of an epoxy resin,

(b) 10-70 % by weight of a maleimide-triazine resin,

(c) 5-60 % by weight of a polymerizable compound having at least two acrylate or methacrylate groups, and

(d) 0.1-10 % by weight of a radical polymerization initiator, the amount of each of ingredients (a) through (d) being based on the total weight of ingredients (a) through (c).

The present invention will now be described in detail below.

The epoxy resin is suitably a liquid epoxy resin having two or more epoxy groups in its molecule. Examples of suitable epoxy resins include glycidyl ethers of bisphenol A, bisphenol F, bisphenol AD, brominated bisphenol A, glycerin and a polyalkylene oxide; glycidyl esters of dimer acid and isophthalic acid; epoxidized polybutadiene obtained by reaction of polybutadiene with peracetic acid; heterocyclic epoxy resins; and mixtures thereof. Above all, the use of glycidyl ethers of bisphenol A, bisphenol F and bisphenol AD is particularly preferred. Crystalline or solid epoxy resins may be used for the purpose of the invention as long as it can be dissolved in other ingredients of the thermosetting composition such as a (meth)acrylate-containing polymerizable compound which is generally liquid at room temperature. Examples of such solid epoxy resins include glycidyl ethers of resorcin and hydroquinone.

A maleimide-triazine resin is used as a curing agent for the epoxy resin. The maleimide-triazine resin is an addition polymerization type thermosetting polyimide resin having cyanato groups and comprising a maleimide component and a triazine resin component. It can be obtained by reacting a polyfunctional maleimide compound with a polyfunctional cyanate compound in the presence or absence of a catalyst under heating. In this case, the cyanate compound forms a triazine ring upon being heated. As the catalyst for this reaction, an organic metal salt, a tertiary amine, etc. may be used.

As the aforesaid polyfunctional maleimide compound, there can be used, for example, those which are represented by the following general formula (I):

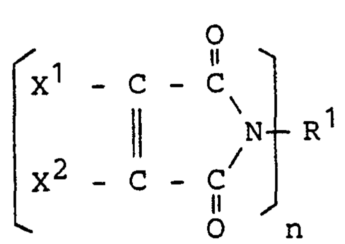

(I)

wherein $R^1$ represents an aromatic or alicyclic organic group having a valence number of 2 to 5, preferably 2, $X^1$ and $X^2$, independently from each other, represent hydrogen, halogen or alkyl, and n represents an integer of 2 to 5 corresponding to the valence number of $R^1$.

The polyfunctional maleimide compound represented by the foregoing general formula (I) can be prepared by reacting a maleic anhydride compound with a polyvalent amino compound in a conventional manner to form a maleamic acid compound, subjecting the maleamic acid compound to dehydrative cyclization. As the polyvalent amino compound, there may be used, for example, phenylenediamine, xylylenediamide, cyclohexanediamine, 4,4′-diaminobiphenyl, bis(4-aminophenyl)methane, bis(4-aminophenyl)ether, bis(4-amino-3-methylphenyl)methane, 2,2-bis(4-aminophenyl)propane, 2,2-bis(4-amino-3-methylphenyl)propane, 2,2-bis(4 amino-3-chlorophenyl)propane and 1,1-bis(4-aminophenyl)-1-phenylethane.

As the aforesaid polyfunctional cyanate compound, there may be used, for example, those which are represented by the following general formula:

$R^2(OCN)_m$ (II)

wherein $R^2$ represents an aromatic group having a valence number of 2 to 5, preferably 2, and m represents an integer of 2 to 5 corresponding to the valence number of $R^2$.

As the polyfunctional cyanate compound represented by the above general formula (II), there may be used, for example, dicyanatobenzene, tricyanatobenzene, dicyanatonaphthalene, 4,4-dicyanatobiphenyl, bis-(4-dicyanatophenyl)methane, 2,2-bis(4- cyanatophenyl)propane, 2,2-bis(3,5-dichloro-4-cyanatophenyl)-propane, and bis(4-cyanatophenyl)ether.

In preparing the maleimide-triazine resin, the weight ratio of the maleimide compound to the cyanate compound is 10:90 to 40:60, preferably 20:80 to 30:70. If the amount of maleimide compound component is less than the lower limit of the above range, the resulting resin becomes poor in heat resistance. On the other hand, if more than the upper limit of the above range is used, the content of cyanate compound component (cyanato group: -OCN) becomes so small that the resulting resin cannot sufficiently function as a curing agent for the epoxy resin. The maleimide-triazine resin can be used in a liquid or solid state. The maleimide-triazine resin reacts as a curing agent with the epoxy resin to finally give a thermoset product having excellent moisture-proofing property and excellent insulating properties.

The polymerizable compound having at least two (meth)acrylate groups is a monomer or oligomer having two or more acrylic ester or methacrylic ester groups. Illustrative of suitable polyfunctional polymerizable compounds are as follows:

1,4-butanediol di(meth)acrylate;
1,6-hexanediol di(meth)acrylate;
(poly)ethylene glycol di(meth)acrylate;
(poly)propylene glycol di(meth)acrylate;
neopentyl glycol di(meth)acrylate;
neopentyl glycol hydroxypivalate di(meth)acrylate;
bis (meth)acryloxyethyl hydroxyethyl isocyanurate;
tris (meth)acryloxyethyl isocyanurate;
ethylene oxide-modified bisphenol A di(meth)acrylate;
propylene oxide-modified bisphenol A di(meth)acrylate;
trimethylolpropane tri(meth)acrylate;
pentaerythritol tri(meth)acrylate;
pentaerythriaol tetra(meth)acrylate;
dipentaerythritol hexa(meth)acrylate;
an oligoester poly(meth)acrylate prepared from a polybasic acid, polyol and (meth)acrylic acid or from a polybasic acid and a hydroxyalkyl (meth)acrylate;
an epoxy poly(meth)acrylate prepared by reaction of an epoxy resin with (meth)acrylic acid; and
an urethanated poly(meth)acrylate prepared by reaction of a polyisocyanate with a polyol and a hydroxyalkyl (meth)acrylate.

In addition, a monofunctional (meth)acrylic ester compound may also be used in conjunction with the polyfunctional polymerizable compound as a reactive diluent. The reactive diluent is used in an amount of 0-70 % by weight, preferably 0-60 % by weight based on the total weight of the polymerizable compound and the diluent. Examples of such diluents include:

2-hydroxyethyl (meth)acrylate;
2-hydroxypropyl (meth)acrylate;
polyethylene glycol mono(meth)acrylate;
polypropylene glycol mono(meth)acrylate;

polycaprolactone mono(meth)acrylate;
methoxyethyl (meth)acrylate;
ethoxyethyl (meth)acrylate;
butoxyethyl (meth)acrylate;
methylcarbitol (meth)acrylate;
ethylcarbitol (meth)acrylate;
butylcarbitol (meth)acrylate;
(alkyl-substituted)phenoxy (poly)ethylene glycol (meth)acrylate;
(alkyl-substituted)phenoxy (poly)propylene glycol (meth)acrylate;
dicyclopentanyl (meth)acrylate;
dicyclopentenyl (meth)acrylate;
dicyclopentenyoxyethyl (meth)acrylate;
isobornyl (meth)acrylate;
tetrahydrofurfuryl (meth)acrylate;
2-hydroxy-3-phenoxypropyl (meth)acrylate;
(meth)acryloyloxyethyl monophthalate; and
acryloylmorpholine.

As the radical polymerization initiator to used in combination with the aforesaid polymerizable compound, photopolymerization initiators or thermal polymerization initiators may be used. As the photopolymerization initiators, any of those compounds which can generate radicals upon being irradiated with actinic light such as ultraviolet rays may be used. Examples thereof include benzopohenone, benzyl, p,p′-bis(dimethylamino)benzophenone, p,p′-bis(diethylamino)benzophenone, p,p′-dibenzoylbenzene, benzoin methyl ether, benzoin ethyl ether, benzoin propyl ether, benzyl dimethyl ketal, 1-hydroxycyclohexyl phenyl ketone, 2-hydroxy-2-methyl-1-phenylpropane-1-one, 1-(4-isopropylphenyl)-2-hydroxy-2-methylpropane-1-one, anthraquinone, acetonaphthenequinone, 1-tert-butylanthraquinone, phenanthreneanthraquinone, p,p′-bis(dimethylamino)thiobenzophenone, primulin, carbazole, N-methyl-3-nitrocatbazole, xanthone, thioxanthone, chlorothioxanthone, diethylthioxanthone, diisopropylthixanthone, carbon tetrabtomide, ω,ω,ω-tribromomethyl phenyl sulfone, and ω,ω,ω-tribromomethyl phenyl ketone.

These photopolymerization initiators can be used together with a peroxide which functions as a thermal polymerization initiator to be described hereinafter.

As the thermal polymerization initiator, any of those which can generate radicals upon being heated may be used. Such thermal polymerization initiators may be, for example, azo compounds such as azobisisobutyronitrile, azobisdimethylvalelonitrile, azobis-(dimethylmethoxybutyronitrile), etc. and peroxides such as dicumyl peroxide, 1,1-bis(t-butylperoxy)-3,3,5-trimethylcyclohexane, 1,1-bis(t-butylperoxy)-cyclohexane, t-butylperoxy acetate, 2,2-bis(t-butylperoxy)butane, t-butylperoxy benzoate, n-butyl 4,4-bis(t-butylperoxy)valelate, di-t-butyldiperoxy isophthalate, methyl ethyl ketone peroxide, α,α′-bis(t-butylperoxyisopropyl)-benzene, 2,5-dimethyl-2,5-di(t-butylperoxy)hexane, t-butyl cumyl peroxide, di t-butyl peroxide, 2,5-dimethyl-2,5-di-t-butylperoxy)hexyne-3, t-butylperoxy isobutyrate, benzoyl peroxide, acetyl peroxide, and 2,4-dichlorobenzoyl peroxide.

As the thermal polymerization initiator, those which generate radicals when heated to 50 to 150° C, preferably about 70 to about 130° C, are advantageously used. In the case where generation of a nitrogen gas is not desired, peroxides are preferably used in place of the azo compounds which release nitrogen gas upon being decomposed.

The proportions of the epoxy resin (ingredient (a)), maleimide-triazine compound (ingredient (b)), polymerizable compound (ingredient (c)), polymerization initiator (ingredient (d)) and reactive diluent (optional ingredient (e)) in the thermosetting composition are as follows:
ingredient (a): 10-70 % by weight,
ingredient (b): 10-70 % by weight,
ingredients (c) + (e): 5-60 % by weight, and
ingredient (d): 0.1-10 % by weight,
based on the total weight of ingredients (a), (b), (c) and (e). The amount of ingredient (e) is 0-70 % by weight based on the total amount of ingredients (c) and (e).

Preferred amounts of ingredients (a) through (e) are as follows:
ingredient (a): 20-60 % by weight,
ingredient (b): 20-60 % by weight,
ingredients (c) + (e): 10-50 % by weight, and
ingredient (d): 1-6 % by weight,
based on the total weight of ingredients (a), (b) (c) and (e). The preferred amount of ingredient (e) is 0-60 %

by weight based on the total amount of ingredients (c) and (e).

The thermosetting resin composition according to the present invention may further contain a conventional curing agent and/or curing promoter for the epoxy resin, if desired. Such an auxiliary curing agent is preferably a latent curing agent which can react with the epoxy resin at an elevated temperature of, for example 60 °C or more, preferably 100 °C or more. Such a latent curing agent may be an aromatic amine, (e.g. diaminodiphenylsulfone), a boron trifluoride-amine complex, an organometallic compound, an acid anhydride (e.g. methylnagic anhydride or methyltetrahydrophthalic anhydride), a phenol compound, a novolak phenol resin and a nitrogen-containing compound. Of these the use of a nitrogen containing compound is especially preferred. Illustrative of suitable nitrogen-containing compounds are dicyanodiamide, a guanamine (e.g. acetoguanamine or benzoguanamine), a hydrazide (e.g. adipodihydrazide, stearodihydrazide, isophthalodihydrazide or sebacohydrazide), a triazine compound (e.g. 2,4-dihydrazide-6-methylamino-S-triazine) and an imidazole or its derivative.

It is preferred that a curing accelerator be used in conjunction with the above auxiliary curing agent. Such a promoter may be, for example, (1) a urea compound such as 3-substituted-1,1-dimethylureas, (2) a solid solution of 1,8-diaza-bicyclo(5,4,0)undecene-7 and a phenol novolak and (3) an amine adduct obtained by reacting a compound having at least two epoxy groups with a compound having both a hydroxyl group and a tertiary amino group and with an organic compound (except those having an epoxy group or a tertiary amino group) having at least two active hydrogen atoms.

Examples of suitable urea compounds are 3-(3,4-dichlorophenyl)-1,1-dimethylurea, 3-(p-chlorophenyl)-1,1-dimethylurea, 3-phenyl-1,1-dimethylurea, N,N′-(4-methyl-1,3-phenylene)-bis(N,N′-dimethylurea) and 5-(N,N′-dimethylureido)-1-(N″,N″-dimethylureidomethyl)-1,3,3-trimethylcyclohexane.

The solid solution may be obtained by heating a mixture of 1,8-diaza-bicyclo(5,4,0)undecene-7 with a phenol novolak for reaction therebetween, cooling the reaction product, and pulverizing the cooled solids. The phenol novolak is a condensation product obtained by reacting a phenol derivative with an aldehyde. Examples of the phenol derivatives include phenol, alkylphenols, alkoxyphenols, halogenated phenols, resorcinol and bisphenol A. Of these, phenol, p-tert-butylphenol and bisphenol A are particularly preferred. Examples of the aldehyde include furfuraldehyde, chloral, acetoaldehyde or formaldehyde. The content of the undecene-7 in the solid solution is preferably 10-50 % by weight.

Examples of the amine adducts include polyaddition reaction products obtained from (i) 2,3-bis{4-(2,3-epoxypropoxy)phenyl}propane, 1,3 bis{4-[4-(2,3-epoxypropoxy)-α,α-dimethylbenzy]phenoxy}-2-propanol, (ii) condensation products obtained from phenol, formaldehyde and dimethylamine, (iii) adducts of 2-alkyl(with 1-3 carbon atoms)imidazole or 2-alkyl(with 1-3 carbon atoms)-4-methylimidazole and 2,3-epoxypropyl phenyl ether and (iv) piperazine.

An inorganic filler is preferably incorporated into the thermosetting coating composition of the present invention. Illustrative of the inorganic fillers are crystalline silica, fused silica, alumina, titania, calcium carbonate, talc, clay, calcium silicate, mica, glass fibers, glass powder, glass flakes and whiskers of various kinds. The amount of the inorganic filler is 5-80 %, preferably 20-75 % based on the weight of the composition (dry basis). The inorganic filler preferably has an average particle size of 5-50 µm.

In the present invention a thixotropic agent having an average particle size of 100 nm or less is preferably used. Examples of such a thixotropic agent include super-fine silica and alumina, aluminum hydroxide, fibrous magnesium oxysulfate, powdery asbestos, fibrous silica, fibrous potassium titanate, scale-like mica, and a montmorillonite-organic salt composite so called bentonite. The thixotropic agent is used in an amount of 0.1-30 parts by weight, preferably 0.5-15 parts by weight per 100 parts by weight of the epoxy resin.

The above inorganic filler and/or the thixotropic agent are preferably pretreated with a siloxane compound. The use of the filler and thixotropic agent generally adversely affect the stability of the composition. When the filler and thixotropic agent are treated with a siloxane compound, however, the stability or shelf life is improved. Illustrative of suitable siloxane compounds are as follows:

$$R - \underset{R}{\overset{R}{Si}} - O - \underset{R}{\overset{R}{Si}} \left( O \right)_m \underset{R}{\overset{R}{Si}} - R$$

wherein R stands for a hydrocarbyl group such as methyl, ethyl, propyl, vinyl or phenyl and m is a positive integer;

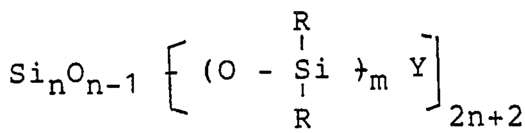

wherein R and m are as defined above and Y is hydrogen, $-OR^1$, $-R^2-CH-CH_2$, $-R^2-NH_2$, $-R^2-COOH$, $-R^2-OH$ where $R^1$ stands for a monovalent hydrocarbyl group, $R^2$ stands for a divalent hydrocarbyl group, and n is a positive integer (The hydrocarbyl group may be an aliphatic, alicyclic or aromatic);

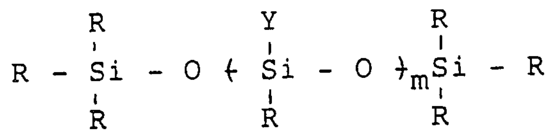

wherein R, Y and m are as defined above;

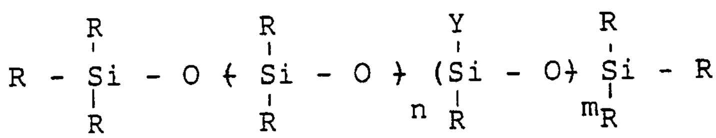

wherein R, Y, m and n are as defined above. The treatment of the filler and the thixotropic agent with the siloxane compound may be performed by mixing the filler or the thixotropic agent with a solution of the siloxane compound and, then, heating the mixture for oxidation of the siloxane compound. The above siloxane compound preferably has a viscosity of 10,000 cSt or less. The amount of the siloxane compound used is 0.1-10 parts by weight, preferably 0.5-5 parts by weight per 100 parts by weight of the filler or thixotropic agent used.

The thermosetting composition may further contain, as desired, a flame retarder, a flame retarding aid, a sedimentation-preventing agent, a dispersing agent or a pigment.

The thermosetting coating composition according to the present invention is stable at room temperature but becomes solid or semi-solid (B-stage resin) when exposed to actinic light such as UV ray or electron beam or when heated at a low temperature of, for example, 130 °C or below. The B-stage resin which still contains unreacted epoxy resin and maleimide-triazine resin is cured when heated at a high temperature of, for example 130-250 °C, to give an infusible, insoluble solid having excellent resistance to heat or chemicals and excellent moisture-proofing property and electrically insulating property.

Thus, the thermosetting composition according to the present invention can be utilized in many applications. In particular, the composition is suitably used as a printing ink for the formation of an insulating layer over a conducting surface such as a wiring pattern-bearing surface of a printed circuit board. That is, since a printed coat obtained with such an ink can be easily solidified by irradiation or heating, it is possible to apply the ink again over the solidified coat. By repeating such a cycle of the application of ink and the conversion of the applied coat into B-stage one, there is obtainable a thick layer free of pin-holes or the like coating defects. The B-stage resin layer is then heated to a high temperature to obtain a cured, insulating layer. The insulating layer may be overlaid with a copper foil for electromagnetic shielding of the printed circuit board. Further, by proving a wiring pattern by, for example, chemical plating on the insulating layer, a multi-layered printed circuit board may be prepared.

The following examples will further illustrate the present invention.

## Examples 1-7

Thermosetting compositions composed of the ingredients shown in Table below were prepared. In the Table:

*1: Bisphenol A epoxy resin, weight epoxy equivalent: 184-194 (manufactured by Yuka-Shell Epoxy Inc.)

*2: Bisphenol A epoxy resin, weight epoxy equivalent: 450-500 (manufactured by Yuka-Shell Epoxy Inc.)

*3: Bismaleimide-triazine resin (manufactured by Mitsubishi Gas Chemicals Co., Ltd.)
*4: Hydroxypivalic acid neopentylglycol diacrylate
*5: Trimethylolpropane triacrylate
*6: Butoxyethylacrylate
*7: 1-Hydroxycyclohexyl phenyl ketone
*8: Benzoyl peroxide
*9: 2-Ethyl-4-methylimidazole
*10: Phenoxy resin, manufactured by Toto Kasei Inc.
*11: Superfine synthetic silica (manufactured by Japan Aerosil Inc.)
*12: Methyl ethyl ketone

| | Example No. | | | | | | | |
|---|---|---|---|---|---|---|---|---|
| Ingredient (parts by weight) | 1 | 2 | 3 | 4 | 5 | 6 | 7 | Comp.1 |
| Epikote 828 *1 | | | 30 | | | | | |
| Epikote 1001 *2 | 30 | 40 | | 40 | 30 | 40 | 30 | 60 |
| BT-2100 *3 | 30 | 40 | 30 | 40 | 30 | 40 | 30 | |
| MANDA *4 | 40 | 20 | | 20 | 40 | 20 | 40 | 40 |
| TMPTA *5 | | | 30 | | | | | |
| Diluent *6 | | | 10 | | | | | |
| Initiator *7 | 2 | 2 | 2 | 2 | 2 | | | 2 |
| Initiator *8 | | | | | | 1 | 1 | |
| Imidazole *9 | | | | | | | | 0.5 |
| Phenototo *10 | | | | | 10 | | 10 | |
| Aerosil #200 *11 | 2 | 2 | 2 | | | | | 2 |
| MEK *12 | | | | 50 | 50 | 50 | 50 | |
| Insulation (ohm) | | | | | | | | |
| Initial | $5.5x10^{14}$ | $4.5x10^{14}$ | $5.0x10^{14}$ | $4.2x10^{14}$ | $4.0x10^{14}$ | $3.0x10^{14}$ | $3.0x10^{14}$ | $2.0x10^{14}$ |
| After boiling | $1.5x10^{13}$ | $2.0x10^{13}$ | $1.0x10^{13}$ | $2.0x10^{13}$ | $1.0x10^{13}$ | $1.5x10^{14}$ | $1.0x10^{13}$ | $3.0x10^{11}$ |

Comparative Example 1

A thermosetting resin composition having the formulation shown in Table above and containing no maleimide-triazine resin was prepared.

Each of the thermosetting compositions of Examples 1-3 and Comparative Example 1 was coated by screen printing on an IPC-B25 comb-like electrode using a 200 mesh screen and the coat was irradiated by UV rays. Such a printing and irradiation operation was repeated 3 times. The resulting B-stage resin coat was then cured at 150 °C for 1 hour. Each of the thermosetting compositions of Examples 4-7 was coated over a polyethylene terephthalate film and the coat was converted into B-stage resin coat by UV irradiation (Examples 4 and 5) or by heating at 120 °C (Examples 6 and 7) to form a laminate. The laminate was then superposed on an IPC-B25 comb-like electrode with the B-stage resin layer being in contact therewith. The assembly was heated in a vacuum laminator to effect press bonding of the resin layer at 80 °C. After cooling, the substrate was removed.

The resulting electrodes bearing the B-stage resin layers were tested for their electrical insulation by measuring electric resistivity at an impressed voltage of 500 V before and after immersion in boiling water for 2 hours. The results are also summarized in Table above.

**Claims**

1. A liquid, thermosetting composition comprising the following ingredients (a) through (d):
(a) 10-70 % by weight of an epoxy resin,

(b) 10-70 % by weight of a maleimide-triazine resin,

(c) 5-60 % by weight of a polymerizable compound having at least two acrylate or methacrylate groups, and

(d) 0.1-10 % by weight of a radical polymerization initiator, the amount of each of ingredients (a) through (d) being based on the total weight of ingredients (a) through (c).

2. A composition according to claim 1, wherein said maleimide-triazine resin is capable of curing the epoxy resin when the composition is heated at a temperature of 130-250 °C.

3. A composition according to claim 2, wherein said radical polymerization initiator can polymerize said polymerizable compound when the composition is heated at a temperature of 50-150 °C.

4. A composition according to claim 2, wherein said radical polymerization initiator can polymerize said polymerizable compound when the composition is irradiated by an actinic light.

5. A composition according to claim 1, further comprising a filler.

6. A composition according to claim 1, further comprising ingredient (e) which is a reactive diluent consisting of a compound having only one acrylate or methacrylate group, the amounts of ingredients (a) through (e) being as follows based on the total weight of ingredients (a) through (c) and (e).

ingredient (a): 10-70 % by weight
ingredient (b): 10-70 % by weight
ingredients (c) + (e): 5-60 % by weight
ingredient (d): 0.1-10 % by weight

with the amount of ingredient (e) being up to 70 % by weight based on the total amount of ingredients (c) and (e).

7. A composition according to claim 6, wherein the amounts of ingredients (a) through (e) are as follows:

ingredient (a): 20-60 % by weight
ingredient (b): 20-60 % by weight
ingredients (c) + (e): 10-50 % by weight
ingredient (d): 1-6 % by weight

with the amount of ingredient (e) being up to 60 % by weight based on the total amount of ingredients (c) and (e).

8. A composition according to claim 1, wherein said maleimide-triazine resin is a product obtained by reaction of 10-40 parts by weight of a polyfunctional maleimide compound represented by the following general formula (I):

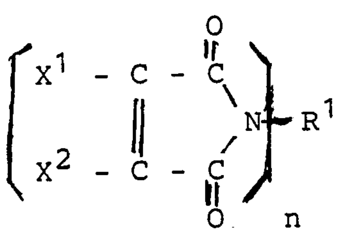

(I)

wherein $R^1$ represents an aromatic or alicyclic group having a valence number of 2 to 5, $X^1$ and $X^2$, independently from each other, represent hydrogen, halogen or alkyl, and n represents an integer of 2 to 5 corresponding to the valence number of $R^1$, with 90-60 parts by weight of a polyfunctional cyanate compound represented by the following general formula (II):

$R^2(OCN)_m$ (II)

wherein $R^2$ represents an aromatic group having a valence number of 2 to 5 and m represents an integer of 2 to 5 corresponding to the valence number of $R^2$.